# EUROPEAN PATENT SPECIFICATION

(11) **EP 0 448 735 B1**
(45) Date of publication and mention of the grant of the patent: **06.08.1997**
(21) Application number: 90105588.9
(22) Date of filing: 23.03.1990
(51) Int. Cl.: G03F 7/16, G03F 7/20

(54) **Method of exposing a peripheral part of wafer**
Randbelichtungsverfahren für Halbleiterscheiben
Procédé pour l'exposition des bords de plaquettes semi-conductrices

(43) Date of publication of application: 02.10.1991
(73) Proprietor: USHIO DENKI KABUSHIKI KAISHA, Tokyo, 100 (JP)
(72) Inventor: Arai, Tesuji, Yokohama-shi, Kanagawa 227 (JP); Suzuki, Shinji, Kawasaki-shi, Kanagawa 214 (JP)
(74) Representative: Betten & Resch

(56) References cited:
- EP-A- 0 325 930
- DE-A- 3 314 156
- DE-A- 3 425 761
- FR-A- 2 151 130
- PATENT ABSTRACTS OF JAPAN vol. 6, no. 264 (E-150)(1142) 23 December 1982, & JP-A-57 162336 (FUJITSU K.K.) 06 October 1982,

## Description

### Background of the Invention

### 1. Field of the Invention

This invention relates to a method of exposing a peripheral part of wafer which is used for a fine pattern formation process in the production of ICs, LSIs or other electronics elements. More particulary, this invention relates to removing, in a development step, an unnecessary portion of a photoresist coated on a semiconductor substrate, typically a silicon wafer, or a substrate consisting of a dielectric, a metal or an insulator.

### 2.Description of the Prior Art

In the manufacture of ICs and LSIs, for forming a fine circuit pattern, a photoresist pattern is formed by coating a photoresist on a silicon wafer or the like and exposing and developing the coated photoresist. The photoresist pattern thus formed is used as a mask to effect ion implantation, etching, lifting-off and other steps.

Usually, the photoresist is coated by spin coating. In the spin coating process, the wafer is spun while pouring photoresist onto the center position of the right side of the wafer, and the poured photoresist is coated on the wafer by centrifugal forces. In this spin coating process, however, the photoresist gets off a peripheral part of the wafer and is brought to the wrong side of the wafer.

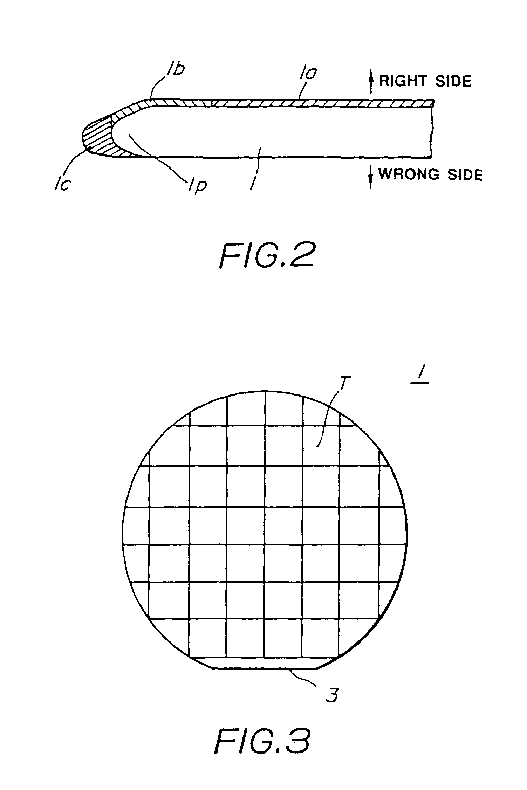

Fig.2 is a cross sectional view showing photoresist coated on a wafer. In the Figure, reference numeral 1 designates a wafer, 1p a peripheral part of wafer, la a photoresist portion on a pattern formation part of the wafer, 1b a photoresist portion on a peripheral part 1p, and 1c a photoresist portion brought to the wrong side of the wafer 1 from the edge thereof. The photoresist portion 1c brought to the back side of the wafer is not illuminated in an exposure step for pattern formation, and if it is a positive photoresist, it remains after the development.

Fig.3 is a typical view showing a circuit pattern formed by exposure on the wafer. Each area labeled T corresponds to one circuit pattern. In a peripheral part of wafer, a correct circuit pattern can not be formed in many cases, or it can be formed with an inferior yield. The photoresist portion 1b on a peripheral part of wafer is substantially unnecessary in the circuit pattern formation. Even if the peripheral part of wafer is exposed by a stepper, the photoresist remains unnecessarily after the development.

The remaining of unnecessary photoresist coated on the peripheral part and brought to the wrong side of the wafer gives rise to the following problem. The wafer with the photoresist coated is conveyed in various steps and by various systems or units. A peripheral part of the wafer thus is sometimes mechanically chucked and sometimes rubs a wall of wafer cassette or like wafer accommodation means. In such cases, the unnecessary photoresist portion on the peripheral part of wafer is liable to be removed and re-attached to a pattern formation portion of wafer. In this case, correct pattern formation can no longer be obtained, thus reducing the yield.

The fact that the unnecessary photoresist remaining on the peripheral part of wafer becomes "refuse" to reduce the yield poses significant problems particularly in view of the recent trend for higher functional level and finer pattern in ICs.

So, for removing the unnecessary photoresist remaining on the peripheral part of wafer, a technique of removing the photoresist by a solvent spray method is in practical use.

In this method, the solvent is sprayed on the wrong side of the peripheral part of wafer, solving the unnecessary photoresist. In this method, however, although the photoresist 1c as shown in Fig.2 can be removed, the unnecessary photoresist 1b on the right side of the peripheral part of wafer cannot be removed. Further, if it is arranged such that the solvent is sprayed on the right side of wafer 1 for removing the unnecessary photoresist 1b, not only there arises the problem caused by scattering of the solvent, it is impossible to remove only the unnecessary photoresist with high controllability and providing for a sharp borderline between the unnecessary photoresist 1b on the peripheral part of wafer and photoresist la on the pattern formation part of wafer which is necessary as a mask layer for a subsequent etching or ion implantation process.

Recently, it has been in practice to expose the unnecessary photoresist on the peripheral part of wafer to remove it in the development process in addition to the exposure step for pattern formation so called "photolithography" (see EP 0 325 930 A1).

In this peripheral part of wafer exposure method, the borderline between the unnecessary photoresist 1b on the peripheral part of wafer and photoresist la necessary for the pattern formation as a mask layer for a subsequent ion implantation process or the like, as shown in Fig.2, can be sharply and with high controllability, so that this method is superior to the solvent spray method.

### Summary of the Invention

An object of the invention is to provide a method of exposing a peripheral part of wafer, which is free from generation of bubbles in the photoresist and also free from pattern defects and permits high yield and productivity to be obtained.

So, in the above prior art of peripheral part exposure method, if the photoresist is irradiated with strong ultraviolet rays from the outset to shorten exposure time, gases that are generated by decomposition and evaporation of organic solvents contained in the photoresist or photochemical reaction of photoresist thereof are not emitted to the outside but become bubbles within the photoresist.

If such bubble formation occurs, the portions with bubbles are spattered when the wafer rubs a wall of wafer cassette or the like. The spattered photoresist is attached as "refuse" to the pattern formation part of the wafer to bring about the problem of pattern defects as noted above.

According to the invention, in a first exposure the illumination intensity is set to a low level so that gases generated in the photoresist material will not be concentrated in any area but are emitted gradually to the outside of the photoresist material. Thus, no bubbles are formed in the photoresist material. In the second exposure, the illumination intensity can be increased without possibility of bubble formation because gases have been substantially emitted at the time of the first exposure. Thus, for the second or more following exposure the turning speed of the wafer can be increased to shorten the exposure time.

More specifically, in a method of exposing a peripheral part of wafer according to the invention, a peripheral part of the wafer is exposed to light guided by single optical fiber lightguide at a first illumination intensity while turning said wafer, exposing the same area to light guided by said single optical fiber lightguide at a second illumination intensity which is higher than the first illumination intensity while continuously turning said wafer again. Thus, no bubbles are formed and high yield of product can be obtained.

### Brief Description of the Drawing

Fig.1 is a schematic representation of a main portion of an exposure apparatus for carrying out an embodiment of method of exposing a peripheral part of the wafer according to the invention;
Fig.2 is a cross sectional view showing photoresist coated on a wafer;
Fig.3 is a typical view showing the shape of an exposed circuit pattern on the wafer; and
Figs.4(a) and 4(b) are graphs showing the relation between the illumination intensity and exposure time in the exposure method according to the invention, with Fig.4(a) showing a case when exposure is done intermittently and Fig. 4(b) showing a case when exposure is done continuously.

### Description of the Preferred Embodiment

This invention will be described concretely hereinafter on the basis of embodiments shown in accompanying drawings.

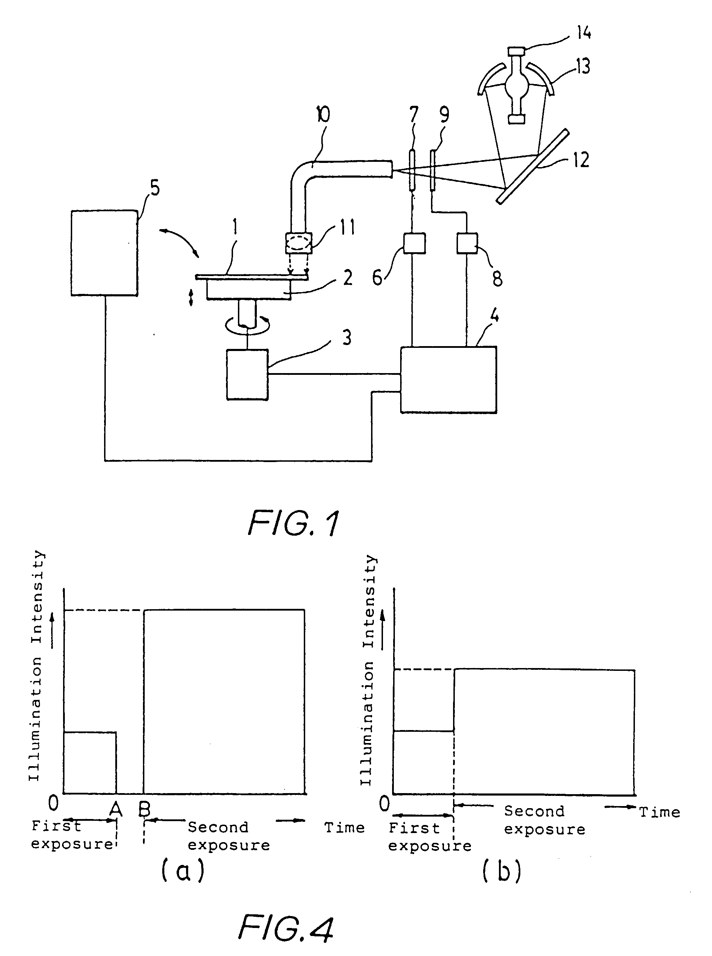

Fig.1 schematically shows a main portion of an exposure apparatus for carrying out one embodiment of method of exposing a peripheral part of wafer according to the invention. Referring to the Figure, reference numeral 1 designates a wafer, 2 is a stage, on which the wafer 1 is set, 3 is a stage drive system for turning the stage 2, 4 is a system controller, 5 is a wafer transport system for transporting the wafer 1 onto the stage 2, 6 is a shutter actuator, 7 is a shutter opened and closed by the shutter actuator 6, 8 is a actuator of a light-reducing filter, 9 is a light-reducing filter consisting of a metal mesh or the like to control the transmission of exposure light, 10 is an optical fiber lightguide for guiding exposure light, 11 is a light emission end of the optical fiber lightguide, 12 is a plane mirror, 13 is an oval light collector, and 14 is a discharge mercury lamp of short arc type (hereinafter referred to as lamp). As the shutter actuator 6 and filter actuator 8, rotary solenoids can be used for instance.

An example of the exposure method using the exposure apparatus shown in Fig.1 will now be described.

The wafer transport system 5 transports the wafer 1 and sets it on the stage 2 according to a signal from the system controller 4. The stage 2, on which the wafer 1 is set, chucks the wafer 1 by a vacuum chuck mechanism (not shown). Subsequently, the stage 2 is caused to turn, and the shutter 7 is opened by the shutter actuator 6 according to a signal from the system controller 4. At this time, the light-reducing filter 9 remains to be on a light path. Light from the lamp 14 is reduced by the filter 9 and emitted from the light emission end 11 of the optical fiber lightguide 10 to effect exposure of the peripheral part of the wafer 1.
This exposure is done at reduced illumination intensity and is called first exposure. The first exposure continues while wafer 1 turns through an angle of 360 degree(1 cycle).

The finish of first exposure is monitored by monitoring mechanism of turning angle(not shown, such as a counter for counting the number of pulses of a pulse motor for stage driving system 3, or a rotary encoder).

The result of this monitoring is transmitted to system controller 4. Monitoring the wafer 1 turning through an angle of 360 degree(finishing first exposure), system controller 4 sends a signal to filter actuator 8 to take away filter 9 from light path. Then the second exposure starts. From the first exposure to second exposure, turning motion of wafer 1 may be continued or stopped. If turning motion is stopped, the shutter 7 is used.

In the second exposure, the peripheral part of wafer 1 is exposed at higher illumination intensity because light-reducing filter 9 is taken away from light-path. The second exposure finishes after added 1 or more cycle of turning of wafer 1.

When the second exposure finishes, the wafer 1 is transported from the stage 2 to a wafer cassette by the wafer transport system 5, and photoresist on the peripheral part of wafer is removed in development process by well-known means.

Figs.4(a) and 4(b) show the illumination intensity for the first exposure and for the second and following exposures, respectively.

Specifically, by using a positive photoresist of phenol novolack type with a thickness of 2 µm, the illumination intensity is set to 200 mW/cm² in the first exposure and 2000 mW/cm² in the second exposure. However, the illumination intensity in each exposure, exposure time and turning speed of course vary depending on the material of the photoresist.

In the above embodiment, by effecting exposure with the wafer temperature held at 100°C, no bubbles are generated even if the illumination intensity for the first exposure is up to 500 mW/cm². In this case, the exposure time for the first exposure can be reduced to about one-third. This is so because the gases produced by the exposure are quickly dispersed in the photoresist material and emitted to the outside thereof, while the photoresist is heated.

The temperature in heating should be less than that of heat-resistance of the photoresist.

Further, instead of turning in 2 or more cycles as in the above embodiment, pluralizing optical fiber lightguides may be used. Each lightguide is set so that it may expose the peripheral part of wafer as shown in Fig.4 (a) or (b). In this case, it is important to set the illumination intensity for the first exposure to be lower than that for the second exposure so that no bubbles will be formed in the photoresist in the first exposure. Therefore, for instance using two lightguides, illumination intensity of light from one lightguide is set lower than another lightguide.

As illumination control means, it is possible to control power supply to the lamp, or use a half mirror or filter in addition to the use of the light-reducing filter.

## Claims

1. A method of exposing a peripheral part of a wafer (1) on which a photoresist (1a, 1b, 1c) is coated comprising the steps of:
exposing said peripheral part of said wafer to light guided by single optical fiber light guide (10) at a first illumination intensity while turning said wafer, said first illumination being at a sufficiently low level so that gases are generated in said photoresist and emitted outside the photoresist without forming bubbles therein;
and, subsequently, exposing said peripheral part of said wafer to light guided by said single optical fiber light guide at a second illumination intensity which is higher than the first illumination intensity, while again continuously turning said wafer,
wherein any portion of said peripheral part of said wafer is exposed at least twice.

2. A method of exposing a peripheral part of a wafer (1) on which a photoresist (1a, 1b, 1c) is coated comprising the steps of:
exposing said peripheral part of said wafer by light guided through first and second optical fiber light guides while turning said wafer;
wherein an illumination intensity at the first exposure by the first optical fiber light guide is at a sufficiently low level so that gases are generated in said photoresist and emitted outside the photoresist without forming bubbles therein;
wherein an illumination intensity at the second exposure by the second optical fiber light guide is higher than the illumination intensity at the first exposure by the first optical fiber light guide;
wherein any portion of said peripheral part of said wafer is exposed first to light having the first illumination intensity and then to light having the second illumination intensity.

3. A method as claimed in claims 1 or 2 wherein said wafer is held in a heated state.

## Patentansprüche

1. Verfahren zum Belichten eines Randteils eines Wafers (1), auf den ein Fotolack (1a, 1b, 1c) aufgetragen ist, mit folgenden Verfahrensschritten:
den Randteil des Wafers mit Licht, das durch einen einzelnen faseroptischen Lichtleiter (10) geleitet wird, mit einer ersten Bestrahlungsintensität zu belichten, während der Wafer gedreht wird, wobei die erste Bestrahlung auf einer genügend niedrigen Stufe erfolgt, so daß im Fotolack Gase erzeugt werden und aus dem Fotolack hinaus austreten, ohne Blasen darin zu bilden;
und nachfolgend den Randteil des Wafers mit Licht, das durch den einzelnen faseroptischen Lichtleiter geleitet wird, mit einer zweiten Bestrahlungsintensität zu belichten, die höher als die erste Bestrahlungsintensität ist, während der Wafer nochmals kontinuierlich gedreht wird;
wobei jeder Teil des Randteils des Wafers wenigstens zweimal belichtet wird.

2. Verfahren zum Belichten eines Randteils eines Wafers (1), auf den ein Fotolack (1a, 1b, 1c) aufgetragen ist, mit folgenden Verfahrensschritten:
den Randteil des Wafers mit Licht zu belichten, das durch einen ersten und einen zweiten faseroptischen Lichtleiter geleitet wird, während der Wafer gedreht wird;
wobei sich eine Bestrahlungsintensität bei der ersten Belichtung durch den ersten faseroptischen Lichtleiter auf einer genügend niedrigen Stufe befindet, so daß im Fotolack Gase erzeugt werden und aus dem Fotolack hinaus austreten, ohne Blasen darin zu bilden;
wobei eine Bestrahlungsintensität bei der zweiten Belichtung durch den zweiten faseroptischen Lichtleiter höher als die Bestrahlungsintensität bei der ersten Belichtung durch den ersten faseroptischen Lichtleiter ist;
wobei jeder Teil des Randteils des Wafers zuerst mit Licht mit der ersten Bestrahlungsintensität belichtet und dann mit Licht mit der zweiten Bestrahlungsintensität belichtet wird.

3. Verfahren wie in Anspruch 1 oder 2 beansprucht, wobei der Wafer in einem erwärmten Zustand gehalten wird.

## Revendications

1. Procédé pour exposer une partie périphérique d'une plaquette (1) recouverte d'un vernis photosensible (1a, 1b, 1c), comportant les étapes suivantes :
exposition de ladite partie périphérique de ladite plaquette à de la lumière guidée par un guide (10) de lumière à fibre optique unique avec une première intensité d'éclairage tout en faisant tourner ladite plaquette, ledit premier éclairage ayant un niveau suffisamment faible pour que des gaz soient produits dans ledit vernis photosensible et émis à l'extérieur du vernis photosensible sans y former de bulles ;
et ensuite, exposition de ladite partie périphérique de ladite plaquette à de la lumière guidée par un guide de lumière à fibre optique unique avec une seconde intensité d'éclairage supérieure à la première intensité d'éclairage, tout en faisant de nouveau tourner continuellement ladite plaquette,
dans lequel toute portion de ladite partie périphérique de ladite plaquette est exposée au moins deux fois.

2. Procédé pour exposer une partie périphérique d'une plaquette (1) recouverte d'un vernis photosensible (1a, 1b, 1c), comportant les étapes suivantes :
exposition de ladite partie périphérique de ladite plaquette à de la lumière guidée à travers un premier et un second guides de lumière à fibre optique tout en faisant tourner ladite plaquette ;
dans lequel une intensité d'éclairage lors de la première exposition par le premier guide de lumière à fibre optique a un niveau suffisamment faible pour que des gaz soient produits dans ledit vernis photosensible et émis à l'extérieur du vernis photosensible sans y former de bulles ;
dans lequel une intensité d'éclairage lors de la seconde exposition par le second guide de lumière à fibre optique est supérieure à l'intensité d'éclairage lors de la première exposition par le premier guide de lumière à fibre optique ;
dans lequel toute portion de la partie périphérique de ladite plaquette est exposée d'abord de la lumière ayant la première intensité d'éclairage et ensuite à de la lumière ayant la seconde intensité d'éclairage.

3. Procédé selon la revendication 1 ou 2, dans lequel ladite plaquette est maintenue dans un état chauffé.
